# EUROPEAN PATENT SPECIFICATION

(11) **EP 1 297 383 B1**
(45) Date of publication and mention of the grant of the patent: **02.01.2008**
(21) Application number: 01951725.9
(22) Date of filing: 21.06.2001
(51) Int. Cl.: G03C 11/02, H05K 1/02

(54) **A METHOD FOR INDIVIDUALISED MARKING OF CIRCUIT BOARDS**
INDIVIDUALISIERTES MARKIERUNGSVERFAHREN FÜR LEITERPLATTEN
PROCEDE DE MARQUAGE INDIVIDUALISE DE CARTES DE CIRCUIT IMPRIME

(30) Priority: 21.06.2000 FI 20001480
(43) Date of publication of application: 02.04.2003
(73) Proprietor: Salmi, Rauno, 02600 Espoo (FI)
(72) Inventor: Salmi, Rauno, 02600 Espoo (FI)
(74) Representative: Ollikainen, Rauno Johannes
(86) International application number: PCT/FI2001/000597
(87) International publication number: WO 2001/098829

(56) References cited:
- DE-A1- 3 147 994
- GB-A- 2 259 584
- US-A- 4 853 317

## Description

The invention relates to a method for individualised marking of a printed circuit board by means of an exposure method in connection with the manufacture of the circuit board.

In industrial manufacturing processes, especially in the assembly industry, it is important that the components used in the assemblies can be identified for use in each assembly, respectively. In assembling are also required instructions for the assembly and/or for performing tests and inspections relating to it. It is also often necessary to be able to trace the batch of a component or the date of manufacture of a component. To solve these problems of identification, the components are marked, for example, with labels adhered to them, with handmade markings, by means of laser or ink-jet printers, or by other corresponding marking methods. In some assembly processes, the assembly line comprises a marking unit at its beginning, in which the components, or some of them, are marked, for example, with markings indicating the batch. However, this type of marking units often prove to be expensive and take up much space. In addition, this type of marking becomes a separate work stage. In some manufacturing processes, such as in manufacturing plastic products, the marking concerning the batch can be made during the manufacture of the product, for example, by means of mould parts comprised in the moulds used for manufacturing a product, which parts are exchangeable by batch, but by such methods the products cannot be individualised.

In circuit board technology, the code of a circuit board or a finished product assembled on it can be included in the etch figure of the circuit board, whereby the marking can be made in connection with the manufacturing process of the circuit board. Usually, this type of markings are effected by incorporating the desired marking in the film used in the manufacture of the circuit board. A marking made in this way cannot, however, be changed during the manufacturing process of the circuit board, and thus an identifier for individualising each circuit board manufactured cannot be accomplished by these methods.

Presently, circuit boards are marked by laser-machining writing or by using printed adhesive bar code labels.

Laser marking is dirty - it produces a lot of dust and gases. In addition, the laser marking device is expensive and takes up much space. Since there has to be a marking device at the beginning of each production line, several devices will also be required. The problem with adhesive labels is their price, and as concerns the electronics currently packed in a very small space, their positioning and fittings. Compared with a conventional surface-mounted device, an adhesive label is more difficult to compose. In addition, the adhesive label has to withstand soldering and washing processes. The markings required by the packing density of current electronics are very small.

It is not advisable to use the technique disclosed in the publication GB 1471163 for marking a printed circuit board which passes through the entire manufacturing process. The photoresist is usually removed from the surface of the circuit board, and it is not practical to leave the photoresist for the serial number alone, especially a photoresist fixed by heating. The technique described basically replaces currently used silk-screen markings. This known method does not relate to individualised identifying marking, for example, serial numbering in the manner complying with the present invention.

The publication DE 3620850 describes the making of markings on film by illuminating the markings through the carrier film. For illumination are used point sources of light, such as LEDs or the ends of optical fibres. Illumination through the film carrying the markings is not suitable for making individualised identification markings on a circuit board in circuit board manufacture. The publication does not disclose the implementation of exposure on the photosensitive surface of the circuit board.

The publication US 4806965 discloses a matrix printer for making markings on the photosensitive material of moving film. This functions to some extent like a known thermal printer, in which the tape passes under the writing head. The publication discloses, among other things, line interlacing of a matrix. The exposure technique described is not suggested for application to the individualised marking of circuit boards.

The publication DE 3147994 discloses a method for batch-specific marking of circuit boards. It does not, however, concern, for example, marking of mass-produced articles for the purpose of marking the circuit board blanks themselves, although the method utilises digital characters written on photosensitive material for individualising a batch. This method does not concern markings exposed directly on the surface of the circuit board, but it rather concerns the manufacture, through particular intermediate stages, of the film to be transilluminated used for making the markings.

The publication US 5337117 shows the making of a photocollage through multiple exposure on the film from several different negative films. The exposure technique described in the publication is not suitable for individualising marking, that is, marking changing from individual product to individual product in connection with photolithography.

Marking refers mainly to visually detectable patterns on the surface of a product or inside it, which patterns are distinguishable from the surface of the product or inside it.

The markings have previously been mainly logos, alignment marks, various patterns, or alphanumeric markings. The markings may also be information in coded form, for example, in the form of bar codes, or information expressed by other coding methods, such as so-called two-dimensional (2D) codes.

In many applications, the marking is to be permanent, or at least difficult to remove and/or alter.

In circuit board manufacture is used, for example, fibreglass sheet coated with copper. The copper surface of this sheet is coated with a photosensitive coating. By exposing this coating through a suitable film or mask, desirable parts of the surface can be etched away using techniques known as such, whereby the desired pattern will remain on the surface of the fibreglass sheet. In circuit board manufacture can also be used so-called additive methods in which the desired pattern is formed, for example, electrolytically instead of by etching. A common feature of the different manufacturing methods is, however, that there is a photosensitive coating on the surface of the circuit board material when the desired pattern is being formed. The desired pattern is often made as a so-called contact print, in which case the film or mask contained by the pattern is on top of the photosensitive coating during exposure. The light used in manufacturing circuit boards may be visible or outside the spectrum of visible light, depending on the coatings used.

The aim of the present invention is to provide a method for making a marking on a circuit board, in which at least a part of the surface of the circuit board is coated, for at least a part of the duration of the manufacturing process, with a photosensitive material for the purpose of manufacturing the circuit board. This object is achieved by the method as defined in claim 1.

The code relating to the invention, which covers a few dozen characters, is only a few millimetres in size in each direction at normal etching accuracy, which is required, for example, in the manufacture of cameras, mobile phones and watches. Carrying out the required photolithography is about ten times cheaper than a laser-machining device. The said marking devices would, in addition, be located in connection with the production line of the circuit board plant, for example, at its very beginning, and not in the electronics plant itself. In this way, marking can be concentrated in fewer places and be carried out by means of more economical devices. Furthermore, the circuit boards will also be individualised already at the very beginning of the manufacturing process. Thus, the circuit boards can be monitored individually starting already from the first exposure stage. In accordance with the invention, only one additional exposure or masking is required in connection with normal exposure.

With respect to prior art in use and known to the applicant, the present invention brings additional advantage, because in this way the circuit boards are marked for quality control already at the first stage of manufacture, even before the pattern on the circuit board is etched. The marking preceding the fitting of the actual electronics thus individualises the circuit boards. This marking is utilised at a plant manufacturing devices from circuit boards.

The method relating to the invention is suitable especially for making markings on circuit boards, because the manufacturing process includes at least partial treatment of the surface of the circuit board with photosensitive material. According to a preferred embodiment of the invention, the marking is made in connection with the manufacturing process of the circuit board, simultaneously with the treatment of the circuit board. In the method relating to the invention, can, instead of visible light and a coating sensitive to it, also be used other radiation types and coatings sensitive to them. For the sake of clarity, the words 'light' and 'photosensitive' are used in the specification to refer also to other types of radiation used in the manufacture of the products.

The method relating to the invention is characterised in that the marking is made on such part of the surface of the circuit board which has been treated with a photosensitive material as a part of the circuit board manufacturing process or for the purpose of making the marking.

The invention is particularly suitable, for example, for making markings on both single- and multi-layer circuit boards. According to a preferred embodiment of the invention, the desired marking is made on a circuit board or on one layer of a multi-layer board at the same time as the pattern to be etched is made. By means of the method relating to the invention, the marking can be made on each, or only on a selected, layer of a multi-layer board. When the marking is made using the same process as in the manufacture of the circuit board itself, the marking is as permanent and accurate as the other patterns formed on the circuit board. The marking made will also be protected in the same way as the patterns on the circuit board forming the circuit board itself.

A marking made according to the method relating to the invention can be formed on the surface of the circuit board or on the coating formed during the manufacture of the circuit board.

By means of the method relating to the invention, all circuit boards manufactured can be provided with individual markings before they are taken into use in assembly.

A marking made according to the method relating to the invention can be made machine-readable. The marking can also be made small in size, a limiting factor being the manufacturing process and its capacity, such as the smallest possible bar width achievable in circuit board manufacture.

A marking made according to the method relating to the invention preferably contains information identifying and/or individualising the circuit board or product made of it. The marking may also contain information on the manufacture, testing, inspection, packing, or other handling process of the product and/or subsequent use of the product, or combinations of such information. By making a marking relating to the manufacturing or other handling process machine-readable, the marking can be used for controlling the manufacturing and other handling processes of the product, such as for controlling the mechanisation or fitting of a circuit board or a product made of it.

The marking may be comprised of alphanumeric or numeric characters, or it may consist of a pattern or patterns, which form a pattern identifiable as a code and/or applicable or intended for use as a code, and combinations of these. In a preferred embodiment of the invention, the marking is, for example, a bar code or other binary code, such as a so-called two-dimensional (2D) code.

According to a preferred embodiment of the invention, the marking made on the product consists of at least a part indicating the kind or type of the circuit board and/or a part indicating the batch. In addition to this information, the marking includes a part individualising each circuit board made. According to one preferred embodiment of the invention, this individualising part is unambiguous for each product, preferably, for example, a consecutive number or corresponding code. According to yet another preferred embodiment of the invention, the marking can be made to contain information on the production line or manufacturing process of the product.

According to one preferred embodiment of the invention, the quality of a processed marking can be compared by means of special readers (verifiers) with verified quality, and the examined quality of the marking can thus also be used to measure the quality of the manufacturing process in question. There may be several such markings on the product, and other markings correlating to the quality of the product, which are also used for identification and other purposes mentioned above.

The apparatus for implementing the method relating to the invention comprises at least one light source and adjustable means for directing the light coming from the light source in accordance with the pattern corresponding to the marking on the photosensitive surface of the product being marked.

In one preferred embodiment of the invention, the means for allowing the light from the light source to pass onto the photosensitive surface of the product are comprised of means of the light source fitted in the light beam directed at the surface to be marked, the said means including areas, the transparency of which is adjustable by means of control means, so as to be either transparent or non-transparent, such as liquid crystal displays (LCD). These means having adjustable transparency are preferably controlled by means incorporated in the manufacturing process of the products or relating to its control, but they may also be controlled by the device's own means. As means allowing light to pass adjustably may also be used, for example, various membranes, films and/or their combinations, by means of which can be formed the pattern corresponding to the desired marking, for example, by placing these membranes or films or other suitable means at suitable locations with respect to each other.

According to another preferred embodiment of the invention, the method implementing the device comprises optical means, such as one or more lenses, between the light source and the means having adjustable transparency and/or optical means, for example, one or more lenses, between the means having adjustable transparency and the photosensitive surface of the product. The optical means, which are between the means having adjustable transparency and the photosensitive surface part of the product, are formed, according to one preferred embodiment of the invention, in such a way that the pattern conveyed, for example, projected by them on the surface of the product, is a pattern adjusted on the means having adjustable transparency, or its reduction. In another preferred embodiment of the invention, the said optical means form a pattern adjusted for the means having adjustable transparency, or its enlargement, on the surface of the product.

In another preferred embodiment of the invention, the adjustably transparent means are fitted against the surface of the product to be marked, or in the immediate vicinity of the surface, at the location where the marking is to be made. When markings are made on circuit boards, on the circuit board is in advance, for example in connection with the designing of the circuit board, determined a place where the marking is to be made. In the film used in circuit board manufacture can easily be formed an area which corresponds to the space required by the marking on the surface of the circuit board, and which area on the film is treated in such a way that the photosensitive surface of the circuit board can be exposed in this area in order to make the marking.

According to another preferred embodiment of the invention, the means for allowing light to pass onto the surface of the product are comprised of an optical fibre bundle in which one end of each fibre is in the vicinity of the light source, and the other end in the vicinity of the photosensitive surface part of the product to be marked. From one or more light sources is directed light, by suitable control means, at the ends of such individual fibres at the end of the optical fibre bundle on the side of the light source, that the light passing through these fibres will form a pattern corresponding to the desired marking on the photosensitive surface part of the product. These light sources and their control means can be used as switchable light sources which adjust the patterning of the exposing light.

According to another preferred embodiment of the invention, as a light source is used the same light source which is used in the manufacturing process of the product for treating the product. In a preferred embodiment of the invention, the means having adjustable transparency comprised in the marking device relating to the invention are fitted together with the optical means comprised in the device in the apparatus used for the manufacture of the product in such a way that the marking of the product will take place simultaneously with the exposure treatment of the product, which is part of its manufacture.

The invention is described in the following by means of a drawing, in which
- Figure 1: shows the principle of the device for implementing the method relating to the invention, and
- Figure 2: shows an embodiment in principle of another device for implementing the method relating to the invention.

In the Figures, the same reference numerals denote parts corresponding to each other.

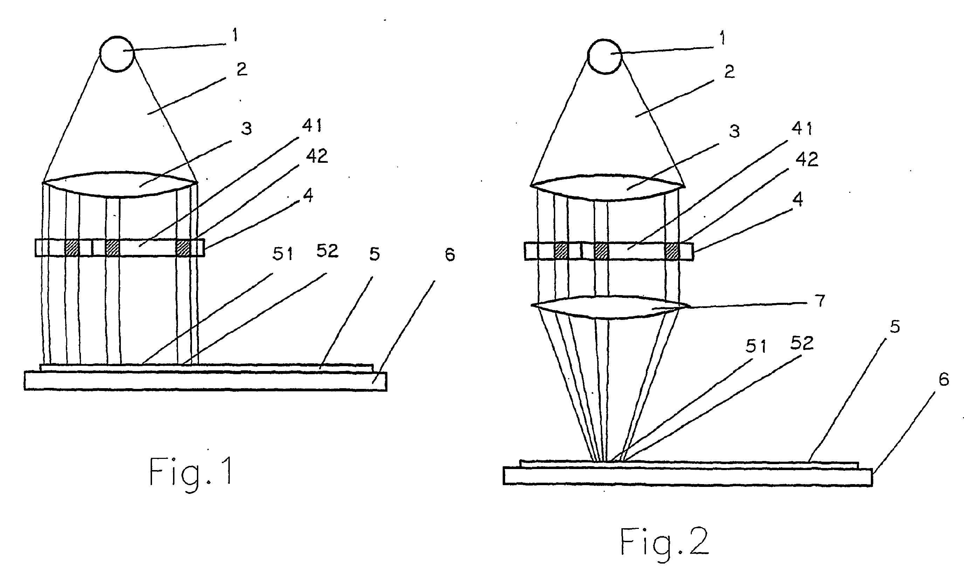

In Figure 1, reference numeral 1 denotes the light source, reference numeral 2 its light beam, which is directed towards the photosensitive surface part 5 of the circuit board 6 to be marked. In the light beam 2 of the light source 1 are fitted optical means 3 and the means 4 having adjustable transparency. The means 4 comprise areas 41 in the direction of propagation of light, which allow light to pass through them, and areas 42, through which light cannot pass, or the transparency of which is substantially lower than the transparency of the areas 41.

The shape and location of areas 41 and 42 has been selected in such a way that a pattern corresponding to the desired marking can be formed by means of them on the photosensitive surface 5 of the circuit board 6. The Figure does not show the means by which the shape and/or location of areas 41 and 42 can be adjusted. In one preferred embodiment of the invention, the means 4 and the areas 41 and 42 in them are controlled in such a way that the light passed through by the pattern formed by areas 41 and 42, forms the desired marking on the photosensitive surface of the circuit board 6, the marking being, for example, a unidimensional code, for example, a bar code, a two-dimensional (2D) code or other desired marking. The light passing through the transparent area 41 of the means 4 exposes area 51 on the photosensitive surface. No light can pass onto the surface 5 through area 42 in the means 4, and area 52 remains unexposed. In this way, a pattern consisting of exposed and unexposed areas and corresponding to the desired marking forms on the surface of the circuit board 6, the said pattern becoming a permanent pattern on the surface of the circuit board in the manufacturing process of the circuit board.

Figure 2 shows another preferred embodiment of the device for implementing the method relating to the invention described in principle. In this embodiment, reference numeral 1 denotes a light source, the light beam 2 of which is directed towards the photosensitive surface 5 of the circuit board 6. In the light beam are fitted means having adjustable transparency 4, and between these means 4 and the light source 1 optical means 3, such as one or more lenses, for directing the light beam at the means 4. Between the means 4 and the circuit board 6 to be marked are fitted second optical means 7, preferably, for example, one or more lenses, by means of which the light passing through the means 4 can be directed at the photosensitive surface 5 of the circuit board 6 in such a way that the pattern formed on the surface 5 is preferably, for example, a reduction of the pattern formed by the means 4. For example, the transparent area 41 is formed into an illuminated area 51 on the surface 5 by means of the optical means 7, the said area having smaller dimensions than area 41. The optical means 3 and 7 may also be mirrors, optical fibres or optical fibre bundles, by means of which the light beam of the light source is directed towards the means 4, and the light passing through the means 4 further to the photosensitive surface 5.

As a light source 1 can be used several kinds of light sources, such as incandescent lamps, fluorescent lamps or discharge lamps, LED light sources, laser light, or other suitable radiation sources. The spectrum of the light or radiation emitted by the light source 1 or radiation source 1 is selected in such a way that it can be used for exposing the photosensitive or radiosensitive coating 5 formed on the surface of the circuit board 6. Correspondingly, the means 4 are selected in such a way that the areas 41 in them allow radiation from the radiation source 1 to pass through them, and that in the means 4 can be formed areas 42, which prevent the radiation emitted from the radiation source 1 from passing through it either completely, or so that the amount of radiation from the radiation source 1 which is allowed to pass through the areas 42 is substantially smaller than the radiation allowed to pass through the areas 41.

The means 4 directing light towards the object may also consist of micro-mirrors, the angle of which with respect to the radiation 2 from the light source 1 can be changed for each individual mirror, respectively, in such a way that light is projected to the photosensitive surface 5 area, thus forming an illuminated area 51, or that light is not projected on the photosensitive surface 5, but area 52 remains unexposed.

In one embodiment of the invention, as a light source 1 is used the same light source as is used in the circuit board 6 manufacturing process for making a circuit board.

## Claims

1. A method for individualised marking of circuit boards, the method comprising a step of exposing on a photosensitive surface (5) required for manufacturing blanks (6) of the circuit boards on each circuit blank, a machine-readable pattern,
**characterised in that** the machine-readable pattern to be exposed by exposing light (2) is selectively changed by using adjustable means (4) which adjustably redirect the exposing light or prevent the exposing light from passing through, or which adjust the patterning of the exposing light by using switchable light sources, and that the machine-readable pattern is subsequently used in the manufacture of the circuit boards, for individualising the blanks (6) in question.

2. A method as claimed in claim 1, **characterised in that** the machine-readable pattern is a two-dimensional code.

3. A method as claimed in claim 1, **characterised in that** the machine-readable pattern is a bar code.

4. A method as claimed in claim 1, **characterised in that** the machine-readable pattern is alphanumeric.

5. A method as claimed in any of the claims 1 to 4, **characterised in that** micro-mirrors are used as the adjustable means (4).

6. A method as claimed in any of the claims 1 to 4, **characterised in that** the exposure is performed through an LCD panel (4).

7. A method as claimed in any of the claims 1 to 4, **characterised in that** the switchable light sources are used as the adjustable means.

8. A method as claimed in any of the claims 5 to 7, **characterised in that** a collimated light projectors (3, 7) is used for collimating the exposing light.

9. A method as claimed in any of the claims 5 to 7, **characterised in that** the exposure is carried out by means of contact exposure.

10. A method as claimed in any of the claims 1 to 4 or 7, **characterised in that** fibre optics is used for directing the exposing light (2) from a light source (1) to the adjustable means (4) and/or to the photosensitive surface (5).

## Patentansprüche

1. Verfahren zum individualisierten Markieren von Leiterplatten, wobei das Verfahren einen Schritt eines Belichtens, auf einer lichtempfindlichen Oberfläche (5), die zum Herstellen der Zuschnitte der Leiterplatten erforderlich ist, auf jedem Leiterplatten-Zuschnitt, eines maschinenlesbaren Musters aufweist, **dadurch gekennzeichnet, dass** das maschinenlesbare Muster, das durch Belichten mit Licht (2) aufgebracht werden soll, wahlweise durch die Verwendung von einstellbaren Einrichtungen (4) geändert wird, die einstellbar das Belichtungslicht ändern oder verhindern, dass Belichtungslicht hindurchführt, oder die die Musterbildung des Belichtungslichts unter Verwendung von umschaltbaren Lichtquellen einstellen, und dass das maschinenlesbare Muster darauf folgend bei der Herstellung der Leiterplatten, um die entsprechenden Zuschnitte (6) zu vereinzeln, verwendet wird.

2. Verfahren nach Anspruch 1, **dadurch gekennzeichnet, dass** das maschinenlesbare Muster ein zweidimensionaler Code ist.

3. Verfahren nach Anspruch 1, **dadurch gekennzeichnet, dass** das maschinenlesbare Muster ein Balkencode ist.

4. Verfahren nach Anspruch 1, **dadurch gekennzeichnet, dass** das maschinenlesbare Muster alphanumerisch ist.

5. Verfahren nach einem der Ansprüche 1 bis 4, **dadurch gekennzeichnet, dass** Mikrospiegel als die einstellbaren Einrichtungen (4) verwendet werden.

6. Verfahren nach einem der Ansprüche 1 bis 4, **dadurch gekennzeichnet, dass** die Belichtung durch eine LCD-Platte (4) durchgeführt wird.

7. Verfahren nach einem der Ansprüche 1 bis 4, **dadurch gekennzeichnet, dass** die umschaltbaren Lichtquellen als die einstellbaren Einrichtungen verwendet werden.

8. Verfahren nach einem der Ansprüche 5 bis 7, **dadurch gekennzeichnet, dass** eine Projektionseinrichtung (3, 7) für kollimiertes Licht für das Kollimieren des Belichtungslichts verwendet wird.

9. Verfahren nach einem der Ansprüche 5 bis 7, **dadurch gekennzeichnet, dass** die Belichtung mittels einer Kontaktbelichtung durchgeführt wird.

10. Verfahren nach einem der Ansprüche 1 bis 4 oder 7, **dadurch gekennzeichnet, dass** Faseroptiken verwendet werden, um das Belichtungslicht (2) von einer Lichtquelle (1) auf die einstellbaren Einrichtungen (4) und/oder auf die lichtempfindliche Oberfläche (5) zu richten.

## Revendications

1. Procédé pour le marquage individualisé de cartes de circuits imprimés, ce procédé comprenant une étape d'exposition sur une surface photosensible (5) appropriée pour la fabrication d'espaces vierges (6) de la carte de circuit imprimé, chacun de ces espaces vierges comprenant un motif décodable par machine,
**caractérisé en ce que** le motif décodable par machine destiné à être exposé sous une lumière d'exposition (2) est modifié de manière sélective en utilisant des moyens réglables (4) qui redirigent de manière ajustable la lumière d'exposition ou empêchent la lumière d'exposition de passer au travers d'eux, ou qui ajustent le motif de la lumière d'exposition en utilisant des sources lumineuses commutables, et **en ce que** le motif décodable par machine est utilisé par la suite dans la fabrication de cartes de circuits imprimés, pour individualiser les espaces vierges (6) en question.

2. Procédé selon la revendication 1, **caractérisé en ce que** le motif décodable par machine est un code bidimensionnel.

3. Procédé selon la revendication 1, **caractérisé en ce que** le motif décodable par machine est un code à barres.

4. Procédé selon la revendication 1, **caractérisé en ce que** le motif décodable par machine est alphanumérique.

5. Procédé selon l'une quelconque des revendications 1 à 4, **caractérisé en ce que** des micro-miroirs sont utilisés comme moyens ajustables (4).

6. Procédé selon l'une quelconque des revendications 1 à 4, **caractérisé en ce que** l'exposition est réalisée au travers d'un panneau (4) d'affichage à cristaux liquides.

7. Procédé selon l'une quelconque des revendications 1 à 4, **caractérisé en ce que** les sources lumineuses commutables sont utilisées en tant que lesdits moyens réglables.

8. Procédé selon l'une quelconque des revendications 5 à 7, **caractérisé en ce qu'**un projecteur collimateur de lumière (3, 7) est utilisé pour collimater la lumière d'exposition.

9. Procédé selon l'une quelconque des revendications 5 à 7, **caractérisé en ce que** l'exposition est réalisée au moyen d'une exposition par contact.

10. Procédé selon l'une quelconque des revendications 1 à 4 ou selon la revendication 7, **caractérisé en que** des fibres optiques sont utilisées pour diriger la lumière d'exposition (2) d'une source lumineuse (1) vers les moyens ajustables (4) et/ou vers la surface photosensible (5).
